# EUROPÄISCHE PATENTSCHRIFT

(11) **EP 3 473 986 B1**
(45) Veröffentlichungstag und Bekanntmachung des Hinweises auf die Patenterteilung: **22.04.2020**
(21) Anmeldenummer: 18185644.4
(22) Anmeldetag: 26.07.2018
(51) Int. Cl.: G01D 5/36, G01D 18/00, H03K 19/007, H03K 3/70

(54) **MULTITURN-DREHGEBER UND VERFAHREN ZUM BETREIBEN EINES MULTITURN-DREHGEBERS**
MULTITURN ROTARY ENCODER AND METHOD FOR OPERATING A MULTITURN ROTARY ENCODER
ENCODEUR À PLUSIEURS ROTATIONS ET PROCÉDÉ DE FONCTIONNEMENT D'UN ENCODEUR À PLUSIEURS ROTATIONS

(30) Priorität: 20.10.2017 DE 102017218767
(43) Veröffentlichungstag der Anmeldung: 24.04.2019
(73) Patentinhaber: Dr. Johannes Heidenhain GmbH, 83301 Traunreut (DE)
(72) Erfinder: WANGLER, Nicolai, 83236 Übersee (DE)

(56) Entgegenhaltungen:
- EP-A1- 0 293 479
- EP-A2- 2 639 556
- DE-A1-102005 006 419
- GB-A- 2 508 788
- JP-A- 2009 058 498

## Beschreibung

### BEZEICHNUNG DER ERFINDUNG

Multiturn-Drehgeber und Verfahren zum Betreiben eines Multiturn-Drehgebers

### GEBIET DER TECHNIK

Die Erfindung betrifft einen sicheren Multiturn-Drehgeber gemäß dem Anspruch 1, sowie ein Verfahren zum Betreiben eines derartigen Multiturn-Drehgebers nach Anspruch 8. Multiturn-Drehgeber werden häufig in der Automatisierungstechnik eingesetzt, um die Winkelpositionen und die Anzahl zurückgelegter Umdrehungen von Wellen zu messen.

### STAND DER TECHNIK

Positionsmesseinrichtungen zur Messung der Winkelposition einer Welle sind aus einer Vielzahl von Druckschriften bekannt. Derartige Positionsmesseinrichtungen werden als Drehgeber bezeichnet. Ist eine Positionsmesseinrichtung darüber hinaus so ausgeführt, dass neben der Winkelposition der Welle auch die Anzahl der von der Welle zurückgelegten Umdrehungen messbar ist, spricht man von einem Multiturn-Drehgeber.

Für die Ausführung der Multiturn-Einheit, also der Einheit zur Feststellung der Anzahl der zurückgelegten Umdrehungen der Welle sind grundsätzlich zwei Lösungen bekannt, zum einen getriebebasierte Multiturn-Einheiten, zum anderen zählerbasierte Multiturn-Einheiten.

Zählerbasierte Multiturn-Einheiten ermitteln die Anzahl zurückgelegter Umdrehungen einer Welle durch Zählen der Umdrehungen eines Codeträgers, der unmittelbar von der Welle angetrieben wird und somit die gleiche Anzahl von Umdrehungen wie die zu messende Welle zurücklegt. Auf dem Codeträger ist ein Code angeordnet, der von einer Abtasteinheit abgetastet wird. Aus den mit der Abtasteinheit ermittelten Positionssignalen werden in einer Zählelektronik Zählsignale für einen Zähler generiert, der die Anzahl vollständiger Umdrehungen des Codeträgers und somit der Welle drehrichtungsabhängig zählt.

Um den Zählerstand des Zählers auch bei ausgeschalteter Hauptstromversorgung, also beispielsweise wenn die Maschine, in der der Multiturn-Drehgeber betrieben wird, ausgeschaltet ist, zu speichern und darüber hinaus die Zählfunktion zu erhalten, sind zählerbasierte Multiturn-Einheiten häufig mit einer Batterie ausgestattet, die bei Ausfall der Hauptstromversorgung die Energieversorgung zumindest der Multiturn-Einheit des Drehgebers übernimmt.

Die EP 1 462 771 A2 beschreibt beispielsweise einen Multiturn-Drehgeber mit einer zählerbasierten Multiturn-Einheit, die im ausgeschalteten Zustand mit einer Batterie betrieben ist.

Die DE 10 2008 015 837 A1 beschreibt ein Positionsmessgerät basierend auf einem induktiven Abtastprinzip, das einen Batteriebetrieb aufweist. Auch dieses Positionsmessgerät ist gut geeignet, als Multiturn-Drehgeber ausgeführt zu werden.

Die JP2009058498 offenbart eine Winkelmessvorrichtung. Die GB2508788 offenbart ein System zur Detektion eines Taktgeberfehlers.

Im Batteriebetrieb werden diese Positionsmessgeräte gepulst betrieben, d.h. zumindest die Komponenten, die zur Erzeugung der gemäß dem physikalischen Messprinzip benötigten Messgröße (z.B. Licht bei optischen Positionsmessgeräten, ein elektromagnetisches Feld bei induktiven Positionsmessgeräten,...) dienen, werden lediglich für die Dauer der Messung eingeschaltet. Auf diese Weise wird der Stromverbrauch gesenkt und die Lebensdauer der Batterie erhöht. Die Messungen werden in zeitlichen Abständen vorgenommen, die gewährleisten, dass jede Umdrehung der zu messenden Welle sicher erfasst wird.

Ein Unsicherheitsfaktor ist es, dass ein zumindest zeitweiser Ausfall der Messpulse dazu führen kann, dass im Batteriebetrieb Umdrehungen der Welle nicht gezählt werden. Nach dem Wiedereinschalten der Hauptstromversorgung besteht somit ein Restrisiko, dass der Zählerstand der Multiturn-Einheit nicht stimmt. Dies ist insbesondere bei sicherheitsrelevanten Anwendungen kritisch, da eine Fehlmessung zu einer Beschädigung der Maschine, an der der Multiturn-Drehgeber betrieben wird, führen kann oder sogar eine Gefahr für das Bedienpersonal der Maschine entstehen kann.

### ZUSAMMENFASSUNG DER ERFINDUNG

Es ist eine Aufgabe der Erfindung, einen Multiturn-Drehgeber mit verbesserter Betriebssicherheit anzugeben. Weiter ist es Aufgabe der Erfindung, ein Verfahren zum Betreiben eines derartigen Multiturn-Drehgebers anzugeben.

Der erste Teil der Aufgabe wird gelöst durch einen Multiturn-Drehgeber nach Anspruch 1.

Es wird nun ein Multiturn-Drehgeber vorgeschlagen, mit
- einem Teilungsträger mit einer Messteilung,
- einer Abtasteinrichtung mit der die Messteilung zur Erzeugung von Positionssignalen abtastbar ist,
- einer Verarbeitungseinheit, mit der die Positionssignale zu Positionswerten verarbeitbar sind,
- einer Schnittstelleneinheit zur Kommunikation mit einer Folgeelektronik über einen Datenübertragungskanal und
- einem ersten Taktgenerator zur Erzeugung eines Messtaktsignals zur Steuerung der Abtastung der Messteilung in einem Pulsbetrieb,
wobei eine Taktüberwachungseinheit vorgesehen ist, der das Messtaktsignal und/oder ein aus dem Messtaktsignal resultierendes Taktsignal zur Überwachung zugeführt ist und die einen zweiten Taktgenerator zur Erzeugung eines Testtaktsignals, eine erste Vergleichereinheit, der das Testtaktsignal und eines der zu überwachenden Taktsignale zugeführt ist und in der ein Vergleich der zugeführten Taktsignale durchführbar ist und einen Fehlerspeicher, in dem ein Ergebnis des Vergleichs als Statusinformation speicherbar ist, umfasst.

Der zweite Teil der Aufgabe wird gelöst durch ein Verfahren zum Betreiben eines Multiturn-Drehgebers nach Anspruch 8.

Hier wird ein Verfahren zum Betreiben eines Multiturn-Drehgebers vorgeschlagen, mit
- einem Teilungsträger mit Messteilung,
- einer Abtasteinrichtung mit der die Messteilung zur Erzeugung von Positionssignalen abgetastet wird,
- einer Verarbeitungseinheit, mit der die Positionssignale zu Positionswerten verarbeitet werden,
- einer Schnittstelleneinheit zur Kommunikation mit einer Folgeelektronik über einen Datenübertragungskanal und
- einem ersten Taktgenerator zur Erzeugung eines Messtaktsignals zur Steuerung der Abtastung der Messteilung in einem Pulsbetrieb,
wobei eine Taktüberwachungseinheit vorgesehen ist, der das Messtaktsignal und/oder ein aus dem Messtaktsignal resultierendes Taktsignal zur Überwachung zugeführt wird und die einen zweiten Taktgenerator zur Erzeugung eines Testtaktsignals, eine erste Vergleichereinheit, der das Testtaktsignal und eines der zu überwachenden Taktsignale zugeführt wird und in der ein Vergleich der zugeführten Taktsignale durchgeführt wird und einen Fehlerspeicher, in dem ein Ergebnis des Vergleichs als Statusinformation gespeichert wird, umfasst.

Weitere Vorteile eines erfindungsgemäßen Multiturn-Drehgebers, sowie eines erfindungsgemäßen Verfahrens zum Betreiben eines derartigen Multiturn-Drehgebers, ergeben sich aus den abhängigen Ansprüchen, sowie aus der nachfolgenden Beschreibung der Ausführungsformen.

### KURZE BESCHREIBUNG DER ZEICHNUNGEN

Es zeigt
- Figur 1: ein Blockschaltbild eines erfindungsgemäßen Multiturn-Drehgebers,
- Figur 2: ein Prinzipschaltbild einer Taktüberwachungseinheit,
- Figur 3A: ein Signaldiagramm von zu überwachenden Taktsignalen,
- Figur 3B: ein Signaldiagramm von zu überwachenden Taktsignalen bei aktivem Testsignal und
- Figur 4: ein Blockschaltbild einer weiteren Ausführungsform eines erfindungsgemäßen Multiturn-Drehgebers.

### BESCHREIBUNG DER AUSFÜHRUNGSFORMEN

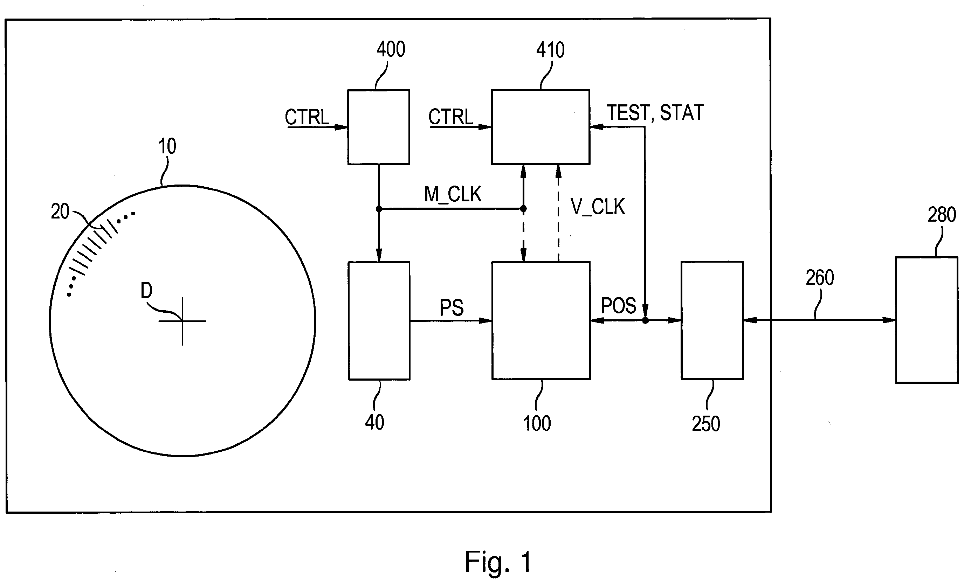

Figur 1 zeigt ein Blockschaltbild eines erfindungsgemäßen Multiturn-Drehgebers. Er umfasst einen Teilungsträger 10 mit einer Messteilung, wenigstens eine Abtasteinrichtung 40, eine Verarbeitungseinheit 100, sowie eine Schnittstelleneinheit 250.

Der Teilungsträger 10 ist ringförmig oder als kreisrunde Scheibe ausgestaltet und für den Betrieb des Multiturn-Drehgebers um einen Drehpunkt D drehbar gelagert und drehfest mit einer Welle verbunden, deren Winkelstellung und Anzahl zurückgelegter Umdrehungen mit dem Multiturn-Drehgeber gemessen werden soll. Die Messteilung ist radial um den Drehpunkt D angeordnet und weist wenigstens eine Teilungsspur 20 auf, deren Abtastung eine Positionsbestimmung (Winkelbestimmung) erlaubt.

Die Abtasteinrichtung 40 ist geeignet ausgestaltet, um die Messteilung auf dem Teilungsträger 10 abzutasten und in Abhängigkeit des Drehwinkels des Teilungsträgers 10 positionsabhängige (winkelabhängige) Positionssignale PS zu generieren. Die Positionssignale PS können analoge, oder digital codierte Signale umfassen.

Die vorliegende Erfindung ist auf kein physikalisches Abtastprinzip festgelegt. So können an sich bekannte induktive, lichtelektrische, magnetische oder kapazitive Abtastprinzipien zum Einsatz kommen. Bei lichtelektrischer Abtastung umfasst die Abtasteinrichtung 40 beispielsweise eine Lichtquelle, deren Licht abhängig von der Winkelposition des Teilungsträgers von der Messteilung moduliert wird, sowie einen Photodetektor, mit dem das modulierte Licht detektiert wird. Bei einer induktiven Abtastung umfasst die Abtasteinrichtung eine Sendespule, die ein elektromagnetisches Feld erzeugt, das von der Messteilung auf dem Teilungsträger moduliert wird. Für den Empfang des modulierten Feldes sind Empfängerspulen vorgesehen.

Die Positionssignale PS sind der Verarbeitungseinheit 100 zugeführt, die diese zu einem Positionswert POS verarbeitet und an die Schnittstelleneinheit 250 ausgibt. Auf die Verarbeitung wird hier nicht weiter eingegangen, es können Verarbeitungsschritte wie Signalkorrektur, Demodulation, Digitalisierung, etc. abgearbeitet werden.

Die Schnittstelleneinheit 250 dient zur Kommunikation mit einer Folgeelektronik 280 über einen Datenübertragungskanal 260. Die Schnittstelleneinheit 250 kann als serielle Schnittstelle ausgeführt sein, d.h. die Datenübertragung über den Datenübertragungskanal 260 erfolgt in Form von seriellen Datenströmen, bzw. Datenpaketen.

Erfindungsgemäß weist der Multiturn-Drehgeber wenigstens einen Betriebsmodus auf, in dem die Abtastung der Messteilung gepulst erfolgt. Ein Pulsbetrieb kommt häufig dann zum Einsatz, wenn Energie gespart werden soll, beispielsweise wenn eine Hauptstromversorgung ausfällt oder abgeschaltet wird und der Multiturn-Drehgeber von einer Batterie mit Energie versorgt wird. Im Pulsbetrieb erfolgt die Abtastung der Messteilung und die Verarbeitung der Positionssignale PS zu Positionswerten POS nicht mehr kontinuierlich, sondern nur in definierten Zeitabständen, die durch ein Messtaktsignal M_CLK bestimmt werden, das von einem ersten Taktgenerator 400 generiert wird. Das Messtaktsignal M_CLK ist hierzu der Abtasteinrichtung 40 und ggf. der Verarbeitungseinheit 100 zugeführt. In der Abtasteinrichtung 40 erfolgt die Erzeugung der physikalischen Messgröße, deren positionsabhängige Veränderung zur Positionsmessung genutzt wird, nur noch für die Dauer einer Messung. So wird beim lichtelektrischen Abtastprinzip die Lichtquelle nur für die Dauer der Messung eingeschaltet, beim induktiven Abtastprinzip die Sendespule zur Erzeugung des elektromagnetischen Feldes nur zeitweise mit Strom versorgt, etc. Zusätzlich können im Pulsbetrieb auch weitere Komponenten zur Detektion der Messgröße und zur Verarbeitung detektierter Positionssignale zu Positionswerten nur zeitweise mit Strom versorgt werden.

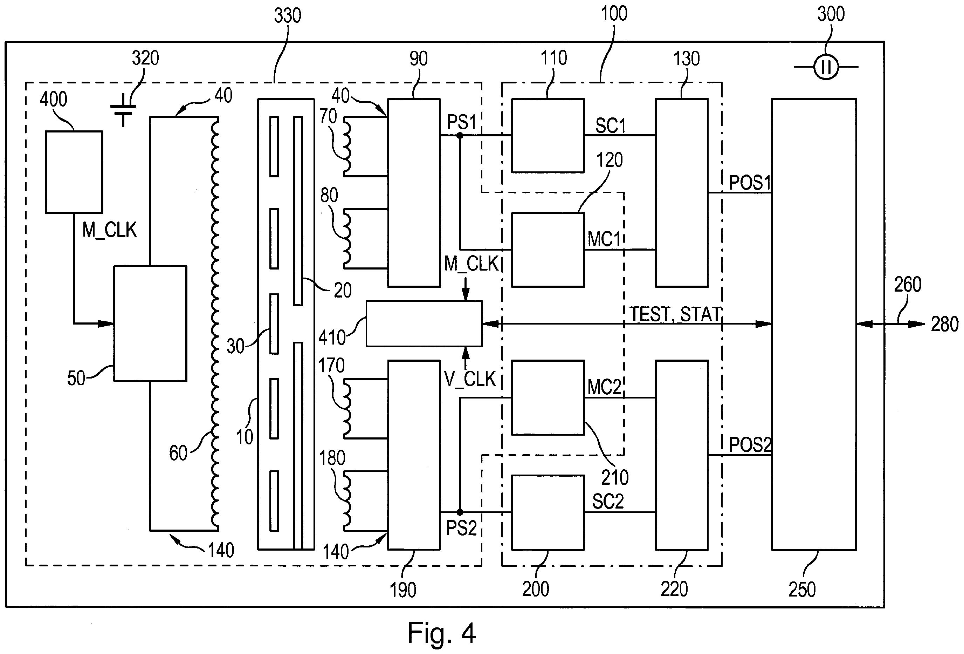

Im Pulsbetrieb kann der Funktionsumfang des Multiturn-Drehgebers gegenüber einem Normalbetrieb reduziert sein. Wie unten bei dem anhand von Figur 4 beschriebenen konkreten Ausführungsbeispiels gezeigt werden wird, kann die Funktion des Multiturn-Drehgebers auf die Bestimmung eines (oder mehrerer) Multiturn-Codewörter eingeschränkt sein, die die Anzahl der Umdrehungen der mit dem Multiturn-Drehgeber gekoppelten Welle angibt. Hierzu werden auch nur die für diesen Zweck benötigten Komponenten mit Energie versorgt. Diese Variante ist besonders vorteilhaft, wenn auch im ausgeschalteten Zustand einer Maschine (und des mit einer Welle der Maschine verbundenen Multiturn-Drehgebers) gewährleistet werden muss, Umdrehungen der Welle zu erfassen, so dass nach dem Wiedereinschalten der Maschine die korrekte Umdrehungszahl vorliegt. Im Normalbetrieb, also bei eingeschalteter Hauptstromversorgung kann dann sofort ein vollständiger Positionswert POS gebildet werden, der das Multiturn-Codewort (Anzahl der Umdrehungen), sowie ein Singleturn-Codewort (Winkelstellung der Welle) umfasst.

Wie eingangs erwähnt, ist eine mögliche Fehlerquelle bei einem Multiturn-Drehgeber mit Pulsbetrieb, dass durch einen (zumindest zeitweisen) Ausfall des ersten Taktgenerators 400 Umdrehungen der Welle nicht erfasst werden und so nach dem Wiedereinschalten der Hauptstromversorgung ein falsches Multiturn-Codewort vorliegt. Erfindungsgemäß umfasst der Multiturn-Drehgeber deshalb weiter eine Taktüberwachungseinheit 410, die das Messtaktsignal M_CLK überwacht.

Im dargestellten Beispiel ist der Taktüberwachungseinheit 410 direkt das Messtaktsignal M_CLK zugeführt. Anstatt dessen kann der Taktüberwachungseinheit 410 aber auch ein vom Messtaktsignal M_CLK abgeleitetes Taktsignal zugeführt sein. Abgeleitete Taktsignale resultieren aus Funktionsabläufen, die vom Messtaktsignal M_CLK gesteuert werden, beispielsweise in der Abtasteinrichtung 40 oder in der Verarbeitungseinheit 100. Sie weisen die gleiche Frequenz, bzw. Periodendauer wie das Messtaktsignal M_CLK auf, können aber zum Messtaktsignal M_CLK phasenverschoben sein und/oder ein abweichendes Puls-/Pausenverhältnis haben. In Figur 1 ist ein (optionales) abgeleitetes Taktsignal V_CLK eingezeichnet, das eine abgeschlossene Positionsmessung, bzw. einen abgeschossenen Zählvorgang in der Verarbeitungseinheit 100 signalisiert. Weitere Beispiele für abgeleitete Taktsignale werden in der Beschreibung des Ausführungsbeispiels von Figur 4 angegeben.

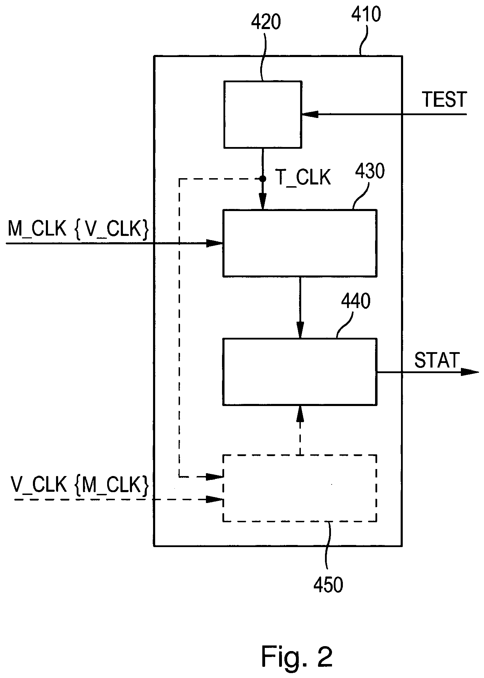

Figur 2 zeigt ein Blockdiagramm einer Taktüberwachungseinheit 410. Sie umfasst einen zweiten Taktgenerator 420, eine erste Vergleichereinheit 430, sowie einen Fehlerspeicher 440.

Der zweite Taktgenerator 420 erzeugt ein Testtaktsignal T_CLK, dessen Frequenz von der Frequenz des Messtaktsignals M_CLK abweicht. Somit stehen in der Taktüberwachungseinheit 410 zwei Taktsignale mit bekannten Signalparametern zur Verfügung. Die Taktsignale sind der ersten Vergleichereinheit 430 zugeführt, die durch Vergleich von Signalparametern feststellt, ob die Taktsignale im Rahmen einer geforderten Genauigkeit funktionieren. Das Ergebnis des Vergleichs ist im Fehlerspeicher 440 als Statusinformation STAT speicherbar und von dort zur Folgeelektronik 280 übertragbar. Für die Übertragung kann ein entsprechender Befehl vorgesehen sein, mit dem die Folgeelektronik 280 die Statusinformation STAT vom Multiturn-Drehgeber anfordert. Die Statusinformation STAT kann aber auch automatisch einer Datenübertragung hinzugefügt werden, beispielsweise als Teil eines Datenrahmens zur Übertragung eines Positionswertes POS zur Folgeelektronik 280.

Eine im Fehlerspeicher 440 gespeicherte Statusinformation STAT, die einen Fehler beim Vergleich der Taktsignale anzeigt, kann nach der Übertragung zur Folgeelektronik 280 gelöscht werden, beispielsweise durch einen Befehl der Folgeelektronik 280.

Wie durch die geschweiften Klammern angedeutet, kann der Taktüberwachungseinheit 410 anstelle des Messtaktsignals M_CLK alternativ auch das abgeleitete Taktsignal V_CLK zugeführt sein.

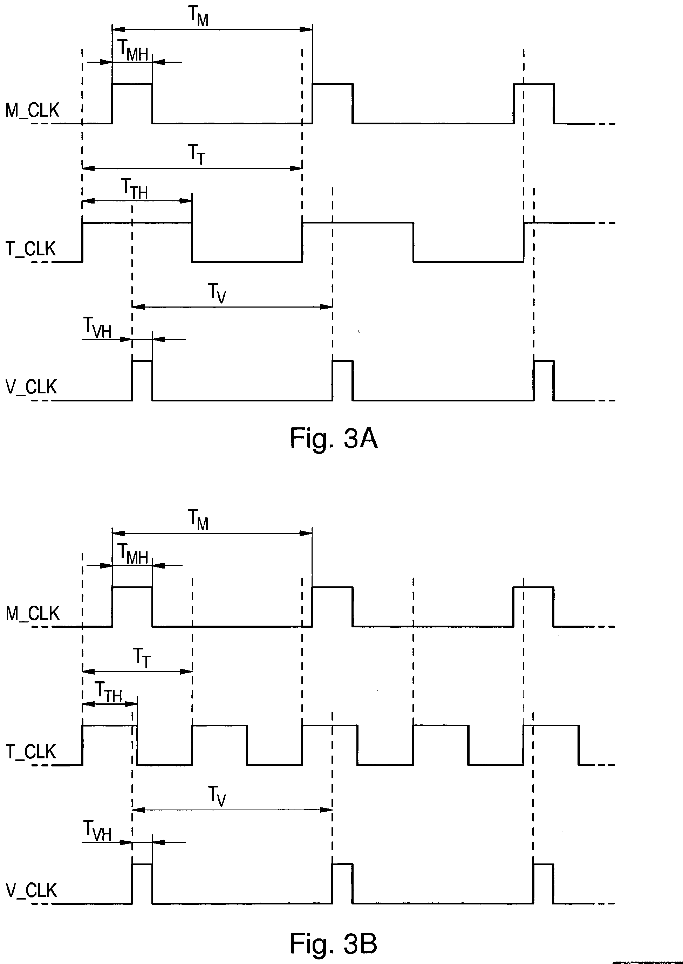

In vorteilhafter Weiterbildung kann die Taktüberwachungseinheit 410 eine zweite Vergleichereinheit 450 umfassen, der das Testtaktsignal T_CLK und, wiederum alternativ, entweder das abgeleitete Taktsignal V_CLK oder das Messtaktsignal M_CLK zugeführt ist. Die zweite Vergleichereinheit 450 entspricht in ihrer Funktionsweise der ersten Vergleichereinheit 430. Während die erste Vergleichereinheit 430 jedoch das Testtaktsignal T_CLK als Zeitbasis für den Vergleich und das Messtaktsignal M_CLK (optional das abgeleitete Taktsignal V_CLK) als zu vergleichendes Taktsignal nutzt, dient bei der zweiten Vergleichereinheit 450 das abgeleitete Taktsignal V_CLK (wiederum optional das Messtaktsignal M_CLK) als Zeitbasis und das Testtaktsignal T_CLK als zu vergleichendes Taktsignal. Dies wird im Folgenden anhand der Signaldiagramme, die in den Figuren 3A und 3B dargestellt sind, näher erläutert. In diesem Beispiel wird angenommen, dass der ersten Vergleichereinheit 430 das Messtaktsignal M_CLK und der zweiten Vergleichereinheit 450 das abgeleitete Taktsignal V_CLK zugeführt ist. Figur 3A zeigt die Taktsignale im ungestörten Pulsbetrieb, während in Figur 3B der Fall dargestellt ist, in dem durch ein Testsignal TEST ein Fehler beim Vergleich der Taktsignale erzwungen wird.

Anhand des in Figur 3A dargestellten Signaldiagramms soll nun ein Beispiel für einen Vergleich von Signalparametern der Taktsignale gegeben werden. Die Signalparameter, die die Taktsignale eindeutig bestimmen, sind beispielsweise die Periodendauer und die Dauer des Highpegels, die zum einen die Frequenz und zum anderen das Tastverhältnis (Quotient aus der Dauer des Highpegels und der Periodendauer) angeben. Für die zu vergleichenden Taktsignale bedeutet das, dass das Messtaktsignal M_CLK durch eine Periodendauer T_{M} und eine Dauer des Highpegels T_{MH} und das Testtaktsignal T_CLK durch eine Periodendauer T_{T} und eine Dauer des Highpegels T_{TH} bestimmt sind.

Im dargestellten Beispiel ist die Periodendauer T_{T} des Testtaktsignals T_CLK so gewählt, dass sie länger als die Periodendauer T_{M} des Testtaktsignals T_CLK und kürzer als die Summe aus der Periodendauer T_{M} des Testtaktsignals T_CLK und der Dauer des Highpegels T_{MH} ist. Das bedeutet, dass je nach Lage des Testtaktsignals T_CLK zum Messtaktsignal M_CLK während einer Periode des Testtaktsignals mindestens eine und höchstens zwei steigende (oder fallende) Signalflanken des Messtaktsignals M_CLK auftreten können. Ebenso kann die Aussage getroffen werden, dass die Gesamtzahl der Signalflanken (steigende und fallende) des Messtaktsignals M_CLK innerhalb einer Periodendauer T_{T} des Testtaktsignals T_CLK mindestens zwei und höchstens drei betragen muss.

Der Nachweis einer oder mehrerer dieser Bedingungen kann als Vergleichskriterium herangezogen werden, um festzustellen, ob das Verhältnis der Taktsignale zueinander stimmt. Stimmt das Verhältnis, so kann mit hinreichender Sicherheit davon ausgegangen werden, dass kein Signalfehler der Taktsignale vorliegt.

Allgemein betrachtet basiert Vergleich der Signalparameter der Taktsignale darauf, nachzuweisen, ob in einem definierten Zeitintervall, das durch eine Signaleigenschaft (Periodendauer, Dauer des Highpegels, Dauer des Lowpegels, Dauer mehrerer Perioden) eines der zu vergleichenden Taktsignale (im dargestellten Fall des Testtaktsignals T_CLK) definiert ist, die Anzahl von Zustandswechseln (steigenden oder/und fallenden Signalflanken) des jeweils anderen Taktsignals (im dargestellten Fall des Messtaktsignals M_CLK) in einem bestimmten Bereich liegt.

Eine mögliche Realisierung hierzu ist es, in der ersten Vergleichereinheit 430 einen flankengetriggerten Zähler vorzusehen, der zu Beginn des Zeitintervalls zurückgesetzt wird, während des Zeitintervalls steigende oder/und fallende Signalflanken zählt und dessen Inhalt nach dem Ende des Zeitintervalls mit dem erwarteten Bereich verglichen wird. Liegt das Ergebnis des Vergleichs außerhalb des erwarteten Bereichs, so kann dies als Fehler im Fehlerspeicher 440 gespeichert werden.

Mit Vorteil ist der Ergebnisbereich so gewählt, dass in jedem Zeitintervall wenigstens eine Signalflanke gezählt wird. Wird darüber hinaus zu Beginn des Zeitintervalls geprüft, ob der Zähler zurückgesetzt ist, kann auf diese Weise die Funktion des Zählers in jedem Zeitintervall nachgewiesen werden.

Eine erweiterte Möglichkeit zur Funktionsprüfung der Taktüberwachungseinheit 410 ist es, einen der Taktgeneratoren (in Figur 2 ist dies der zweite Taktgenerator 420) so auszugestalten, dass seine Periodendauer durch ein Testsignal TEST veränderbar ist und zwar derart, dass bei aktivem Testsignal TEST innerhalb weniger Signalperioden ein Fehler verursacht wird. Dies kann schaltungstechnisch besonders einfach erreicht werden, in dem die Periodendauer verdoppelt oder halbiert (entsprechend einem Halbieren oder Verdoppeln der Taktfrequenz) wird. Das Testsignal TEST kann dem zweiten Taktgenerator 420 über die Schnittstelleneinheit 250 zugeführt werden, so dass eine Funktionsprüfung von der Folgeelektronik 280 aus initiiert werden kann, beispielsweise über einen entsprechenden Befehl, der über den Datenübertragungskanal 260 zur Schnittstelleneinheit 250 übertragen wird.

Das Signaldiagramm in Figur 3B zeigt den Fall, dass die Periodendauer T_{T} des Testtaktsignals T_CLK bei aktivem Testsignal TEST halbiert wird. Dies führt dazu, dass durchschnittlich in jeder zweiten Signalperiode des Testtaktsignals T_CLK ein Fehler in der ersten Vergleichereinheit 430 erkannt wird.

Der durch das aktive Testsignal TEST verursachte Fehler wird im Fehlerspeicher 440 als Statusinformation STAT gespeichert und kann von dort aus zur Folgeelektronik 280 übertragen werden.

Ist in der Taktüberwachungseinheit 410 die (optionale) zweite Vergleichereinheit 450 vorgesehen, so können ihr die Taktsignale V_CLK, T_CLK gegenüber der ersten Vergleichereinheit 430 umgekehrt zugeordnet sein, d.h. das Zeitintervall für den Vergleich wird durch das abgeleitete Taktsignal V_CLK gebildet und das Auftreten der korrekten Anzahl von Zustandswechseln des Testtaktsignals T_CLK je Zeitintervall wird geprüft. Das abgeleitete Taktsignal ist bestimmt durch die Periodendauer Tv und die Dauer des Highpegels T_{VH}. Wird im dargestellten Beispiel von Figur 3A als Zeitintervall also die Periodendauer T_{V} des abgeleiteten Taktsignals V_CLK angenommen, so können im fehlerfreien Betrieb nur wenigstens ein oder maximal zwei Zustandswechsel des Testtaktsignals T_CLK je Zeitintervall auftreten. Das Ergebnis des Vergleichs kann wiederum als Statusinformation STAT im Fehlerspeicher 440 gespeichert werden.

Wie Figur 3B zeigt, wird bei Aktivierung des Testsignals TEST durch die Halbierung der Periodendauer T_{T} des Testtaktsignals T_CLK auch in der zweiten Vergleichereinheit 450 bereits nach kurzer Zeit ein Fehler verursacht, so dass beide Vergleichereinheiten 430, 450 gleichzeitig geprüft werden können.

Die Periodendauer T_{M} des Messtaktsignals M_CLK kann im Rahmen der vorliegenden Erfindung auch einstellbar sein. So kann eine (nicht dargestellte) übergeordnete Steuereinheit im Multiturn-Drehgeber die Periodendauer T_{M} über ein Einstellsignal CTRL, beispielsweise drehzahlabhängig, ändern, so dass bei niedriger Drehzahl der Welle weniger häufig gemessen wird, als bei hoher Drehzahl. Das Einstellsignal CTRL kann in diesem Fall auch der Taktüberwachungseinheit 410 zugeführt sein, so dass entweder durch eine der Änderung der Periodendauer T_{M} des Messtaktsignals M_CLK analoge Änderung der Periodendauer T_{T} des Testtaktsignals T_CLK, oder durch eine Anpassung des Vergleichskriteriums (Anzahl der Zustandsänderungen in einem Zeitintervall) in den Vergleichereinheiten 430, 450, weiterhin ein Vergleich der Taktsignale M_CLK, T_CLK, V_CLK möglich ist.

Figur 4 zeigt ein Blockschaltbild eines erfindungsgemäßen Multiturn-Drehgebers. Er basiert auf einem induktiven Abtastprinzip, wie es beispielsweise in der DE 10 2008 015 837 A1 beschrieben ist, auf die an dieser Stelle explizit verwiesen wird. Komponenten, die bereits in Verbindung mit den Figuren 1 und 2 beschrieben wurden, tragen das gleiche Bezugszeichen.

Der Multiturn-Drehgeber weist einen Teilungsträger 10 mit zwei Teilungsspuren 20, 30, wobei Teilungsträger 10 und Teilungspuren 20, 30 lediglich abstrakt vereinfacht dargestellt sind. In einer tatsächlichen Realisierung kann der Teilungsträger 10 beispielsweise als Codescheibe ausgeführt sein, die drehfest mit der Welle, deren Winkelposition/Umdrehungszahl zu messen ist, verbunden ist. Die Teilungsspuren 20, 30 können aus elektrisch leitfähigen und nicht leitfähigen Bereichen bestehen, die konzentrisch um den Drehmittelpunkt der Codescheibe auf verschiedenen Radien angeordnet sind.

Die zu messende Winkelposition ist in diesem Beispiel analog codiert, d.h. bei der Abtastung der Teilungsspuren 20, 30 entstehen analoge Abtastsignale, aus deren Amplituden und/oder Phasenlagen die Winkelposition der Eingangswelle bestimmt werden kann. Alternativ hierzu kann die Winkelposition aber auch digital codiert sein, beispielsweise indem die Teilungsspuren einen mehrspurigen digitalen Code, z.B. einen Gray-Code, oder einen einspurigen Kettencode, einem sog. "Pseudo Random Code" (PRC) aufweisen. Eine digitale Codierung wird beispielsweise bei lichtelektrischen Abtastprinzipien bevorzugt eingesetzt.

Zur Erzeugung erster Positionssignale PS1 ist nun eine erste Abtasteinrichtung 40 vorgesehen. Sie umfasst eine Erregereinheit 50, die in Verbindung mit einer Erregerspule 60 ein elektromagnetisches Feld erzeugt, dessen Stärke von den Teilungsspuren 20, 30 beeinflusst wird. Zur Detektion des elektromagnetischen Feldes sind zwei Paare von ersten Empfängerspulen 70, 80 vorgesehen, wobei jedes Paar Empfängerspulen 70, 80 zueinander phasenverschobene Positionssignale generiert, die eine drehrichtungsabhängige Positionserfassung ermöglichen. Dabei dient das erste Empfängerspulenpaar 70 der Abtastung der ersten Teilungsspur 20 und das zweite Empfängerspulenpaar 80 der Abtastung der zweiten Teilungsspur 30. In den Empfängerspulen 70, 80 werden im Betrieb Spannungen induziert, deren Amplitude von der Winkelstellung der Codescheibe, bzw. der zu messenden Welle abhängt. Die induzierten Spannungen sind einer ersten Signalverarbeitungseinheit 90 zugeführt, in der sie beispielsweise gefiltert und verstärkt werden, bevor sie als erste Positionssignale PS1 zum Einen an eine erste Singleturn-Auswerteeinheit 110 und zum Anderen an eine erste Multiturn-Auswerteeinheit 120 ausgegeben werden.

Die erste Singleturn-Auswerteeinheit 110 verarbeitet die ersten Positionssignale PS1 zu einem ersten Singleturn-Codewort SC1, das die Winkelposition der zu messenden Welle angibt.

Die erste Multiturn-Auswerteeinheit 120 dagegen verarbeitet die ersten Positionssignale PS1 zu einem ersten Multiturn-Codewort MC1, das die Anzahl der von der zu messenden Welle zurückgelegten Umdrehungen angibt. Die erste Multiturn-Auswerteinheit 120 kann hierzu beispielsweise einen Zähler umfassen, der geeignete Ereignisse der ersten Positionssignale PS1 drehrichtungsabhängig zählt.

Der Nullpunkt der Messung kann manuell festgelegt werden oder beispielsweise durch Erreichen eines Endschalters o.ä. Zum Einstellen des Nullpunkts, von dem aus die Zählung der Umdrehungen beginnt, ist es meist notwendig, vor dem eigentlichen Betrieb der Maschine eine sog. Referenzfahrt vorzunehmen.

Das erste Singleturn-Codewort SC1 und das erste Multiturn-Codewort MC1 sind schließlich einer ersten Codeanschlusseinheit 130 zugeführt, die aus den beiden Werten einen gemeinsamen ersten Positionswert POS1 bildet, der sowohl die aktuelle Winkelposition, als auch die Anzahl der zurückgelegten Umdrehungen beinhaltet.

Die erste Singleturn-Auswerteeinheit 110, die erste Multiturn-Auswerteeinheit 120 und die erste Codeanschlusseinheit 130 sind Teile einer Verarbeitungseinheit 100.

Zur Bildung eines redundanten zweiten Positionswerts POS2 sind, mit Ausnahme der Erregereinheit 50 mit der Erregerspule 60, alle genannten Einheiten identisch ein zweites Mal vorhanden.

Somit ist zur Bildung zweiter Positionssignale PS2 eine zweite Abtasteinrichtung 140 vorgesehen. Dieser sind ebenfalls die Erregereinheit 50 und die Erregerspule 60, die zusammen das elektromagnetische Feld erzeugen, zugeordnet. Zur Detektion des von den Teilungsspuren 20, 30 modulierten elektromagnetischen Feldes sind zwei Paare von zweiten Empfängerspulen 170, 180 vorgesehen, wobei jedes Paar Empfängerspulen 170, 180 zueinander phasenverschobene Positionssignale generiert, die eine drehrichtungsabhängige Positionserfassung ermöglichen. Dabei dient das erste Empfängerspulenpaar 170 der Abtastung der ersten Teilungsspur 20 und das zweite Empfängerspulenpaar 180 der Abtastung der zweiten Teilungsspur 30. Eine zweite Signalverarbeitungseinheit 190 verarbeitet die induzierten Spannungen zu zweiten Positionssignalen PS2.

Neben der Erregereinheit 50 und der Erregerspule 60, die sie mit der ersten Abtasteinrichtung 40 teilt, umfasst die zweite Abtasteinrichtung 140 somit die zweiten Empfängerspulen 170, 180 und die zweite Signalverarbeitungseinheit 190.

Die zweiten Positionssignale PS2 sind einer zweiten Singleturn-Auswerteeinheit 200 zur Bildung eines zweiten Singleturn-Codeworts SC2 und einer zweiten Multiturn-Auswerteeinheit 210 zur Bildung eines zweiten Multiturn-Codeworts MC2 zugeführt. Eine zweite Codeanschlusseinheit 220 bildet schließlich aus dem zweiten Singleturn-Codewort SC2 und dem zweiten Multiturn-Codewort MC2 den zweiten Positionswert POS2.

Die zweite Singleturn-Auswerteeinheit 200, die zweite Multiturn-Auswerteeinheit 210 und die zweite Codeanschlusseinheit 220 sind ebenfalls Teil der Verarbeitungseinheit 100.

Zur Kommunikation mit einer (nicht dargestellten) Folgeelektronik 280 ist eine Schnittstelleneinheit 250 vorgesehen, die Befehle und Daten von der Folgeelektronik 280 über einen Datenübertragungskanal 260 empfängt, bzw. Daten (in Folge von empfangenen Befehlen) an die Folgeelektronik 280 sendet.

Der Schnittstelleneinheit 250 sind in diesem Beispiel die Positionswerte POS1, POS2 zugeführt und können, beispielsweise in Folge eines Positionsanforderungsbefehls, zur Folgeelektronik 280 übertragen werden. Alternativ können die Multiturn-Codeworte MC1, MC2 und die Singleturn-Codeworte SC1, SC2 zur separaten Übertragung an die Folgeelektronik 280 auch direkt der Schnittstelleneinheit 250 zugeführt sein. In diesem Fall kann ggf. auf die Codeanschlusseinheiten 130, 220 verzichtet werden

Im Normalbetrieb werden alle Komponenten des Multiturn-Drehgebers von einer Hauptstromversorgung 300 mit Energie versorgt.

Um bei einem Ausfall der Hauptstromversorgung 300 weiterhin die Multiturn-Codewörter MC1, MC2 speichern und eine Zählung zurückgelegter Umdrehungen vornehmen zu können, werden die dazu benötigten Komponenten in einem batteriegestützten Bereich 330 von einer Batterie 320 mit Energie versorgt. Die Umschaltung vom Normalbetrieb mit Versorgung durch die Hauptstromversorgung 300 zum Batteriebetrieb mit Versorgung des batteriegestützten Bereichs 330 durch die Batterie 320 und umgekehrt erfolgt mit Vorteil automatisch bei Unter/-Überschreiten eines Minimalwerts der Ausgangsspannung der Hauptstromversorgung 300.

Der Batteriebetrieb ist gleichzeitig ein Pulsbetrieb, in dem Positionsmessungen (Bestimmung der Multiturn-Codewörter MC1, MC2) nur intermittierend in definieren Zeitabständen durchgeführt werden. Die Zeitabstände werden wiederum von einem Messtaktsignal M_CLK bestimmt, das vom ersten Taktgenerator 400 erzeugt wird. Zur Überwachung des Messtaktsignals M_CLK, oder/und einem vom Messtaktsignal abgeleiteten Taktsignal V CLK ist im batteriegestützten Bereich 330 auch die Taktüberwachungseinheit 410 angeordnet.

In diesem Beispiel ist das Messtaktsignal M_CLK der Erregereinheit 50 und der Taktüberwachungseinheit 410 zugeführt. Es sei aber darauf hingewiesen, dass das Messtaktsignal M_CLK darüber hinaus auch anderen batteriebetriebenen Komponenten zugeführt sein kann, sofern sie es funktionsbedingt benötigen.

Die Schnittstelleneinheit 250 ist außerhalb des batteriegestützten Bereichs 330 angeordnet. Das bedeutet, dass im Pulsbetrieb keine Kommunikation mit der Folgeelektronik 280 möglich ist. Da das Abschalten der Hauptstromversorgung aber im Normalfall bedeutet, dass die Maschine (z.B. Werkzeugmaschine), an der der Multiturn-Drehgeber betrieben wird, ebenfalls abgeschaltet wird, kann auf diese Funktion verzichtet werden. Auf diese Weise kann der Stromverbrauch im Pulsbetrieb gesenkt und die Lebensdauer der Batterie 320 verlängert werden.

Das abgeleitete Taktsignal V_CLK kann im vorliegenden Ausführungsbeispiel in folgenden Komponenten generiert werden:
- in der Erregereinheit 50 aus dem tatsächlichen Stromfluss der vom Messtaktsignal M_CLK ausgelöst wird,
- in einer Signalverarbeitungseinheit 90, 190 bei der Verarbeitung der in den Empfängerspulen 70, 80, 170, 180 induzierten Spannungen zum Positionssignal PS1, PS2, oder
- in einer Multiturn-Auswerteeinheit 120, 210 bei der Verarbeitung der Positionssignale PS1, PS2 zu den Multiturn-Codewörtern MC1, MC2.

Insbesondere in diesem Ausführungsbeispiel ist es vorteilhaft, unmittelbar nach dem Wiedereinschalten der Hauptstromversorgung 300 zum Einen die Statusinformation STAT vom Fehlerspeicher 440 zur Folgeelektronik 280 zu übertragen, um zu prüfen, ob die überwachten Taktsignale während des Batteriebetriebs fehlerfrei gearbeitet haben, und zum Anderen das Testsignal TEST aktiv zu schalten und zu prüfen, ob die Taktüberwachungseinheit 410 fehlerfrei arbeitet.

Selbstverständlich ist die vorliegende Erfindung nicht auf die beschriebenen Ausführungsbeispiele eingeschränkt. Vielmehr ist ein Fachmann dazu in der Lage, im Rahmen der Ansprüche alternative Ausführungsformen zu gestalten.

## Patentansprüche

1. Multiturn-Drehgeber mit
- einem Teilungsträger (10) mit einer Messteilung (20, 30),
- einer Abtasteinrichtung (40, 140) mit der die Messteilung (20, 30) zur Erzeugung von Positionssignalen (PS, PS1, PS2) abtastbar ist,
- einer Verarbeitungseinheit (100), mit der die Positionssignale (PS, PS1, PS2) zu Positionswerten (POS, POS1, POS2) verarbeitbar sind,
- einer Schnittstelleneinheit (250) zur Kommunikation mit einer Folgeelektronik (280) über einen Datenübertragungskanal (260) und
- einem ersten Taktgenerator (400) zur Erzeugung eines Messtaktsignals (M_CLK) zur Steuerung der Abtastung der Messteilung (20, 30) in einem Pulsbetrieb,
wobei eine Taktüberwachungseinheit (410) vorhanden ist, der das Messtaktsignal (M_CLK) und/oder ein aus dem Messtaktsignal (M_CLK) resultierendes Taktsignal (V_CLK) zur Überwachung zugeführt ist und die einen zweiten Taktgenerator (420) zur Erzeugung eines Testtaktsignals (T_CLK), eine erste Vergleichereinheit (430), der das Testtaktsignal (T_CLK) und eines der zu überwachenden Taktsignale (M_CLK, V_CLK) zugeführt ist und in der ein Vergleich der zugeführten Taktsignale (T_CLK, M_CLK, V_CLK) durchführbar ist und einen Fehlerspeicher (440), in dem ein Ergebnis des Vergleichs als Statusinformation (STAT) speicherbar ist, umfasst.

2. Multiturn-Drehgeber nach Anspruch 1, wobei die Taktüberwachungseinheit (410) weiter eine zweite Vergleichereinheit (450) umfasst, der das Testtaktsignal (T_CLK) und ein weiteres der zu überwachenden Taktsignale (M_CLK, V_CLK) zugeführt sind und in der ein Vergleich der zugeführten Taktsignale (T_CLK, M_CLK, V_CLK) durchführbar ist und ein Ergebnis des Vergleichs ebenfalls als Statusinformation (STAT) im Fehlerspeicher (440) speicherbar ist.

3. Multiturn-Drehgeber nach einem der vorhergehenden Ansprüche, wobei in den Vergleichereinheiten (430, 450) der Vergleich durch Feststellung einer Anzahl von Zustandswechseln eines ersten der zu vergleichenden Taktsignale (T_CLK, M_CLK, V_CLK) innerhalb eines Zeitintervalls, das von einem zweiten der zu vergleichenden Taktsignale (T_CLK, M_CLK, V_CLK) bestimmt wird, durchgeführt wird.

4. Multiturn-Drehgeber nach Anspruch 3, wobei das Zeitintervall durch die Periodendauer des zweiten zu vergleichenden Taktsignals (T_CLK, M_CLK, V_CLK) bestimmt wird.

5. Multiturn-Drehgeber nach einem der Ansprüche 3 oder 4, wobei die Feststellung der Anzahl von Zustandswechseln durch Zählung von steigenden oder/und fallenden Signalflanken des ersten der zu vergleichenden Taktsignale (T_CLK, M_CLK, V_CLK) innerhalb des Zeitintervalls erfolgt.

6. Multiturn-Drehgeber nach einem der vorhergehenden Ansprüche, wobei der Taktüberwachungseinheit (410) ein Testsignal (TEST) zuführbar ist, das eine Änderung der Periodendauer des Testtaktsignals (T_CLK) bewirkt, so dass ein Fehler beim Vergleich der Taktsignale (T_CLK, M_CLK, V_CLK) erzwungen wird.

7. Multiturn-Drehgeber nach einem der vorhergehenden Ansprüche, wobei im Pulsbetrieb nur Komponenten von einer Batterie (320) mit Strom versorgt werden, die sich in einem batteriegestützten Bereich (330) befinden und die Schnittstelleneinheit (250) außerhalb des batteriebetriebenen Bereichs (330) angeordnet ist.

8. Verfahren zum Betreiben eines Multiturn-Drehgeber mit
- einem Teilungsträger (10) mit einer Messteilung (20, 30),
- einer Abtasteinrichtung (40, 140) mit der die Messteilung (20, 30) zur Erzeugung von Positionssignalen (PS, PS1, PS2) abgetastet wird,
- einer Verarbeitungseinheit (100), mit der die Positionssignale (PS, PS1, PS2) zu Positionswerten (POS, POS1, POS2) verarbeitet werden,
- einer Schnittstelleneinheit (250) zur Kommunikation mit einer Folgeelektronik (280) über einen Datenübertragungskanal (260) und
- einem ersten Taktgenerator (400) zur Erzeugung eines Messtaktsignals (M_CLK) zur Steuerung der Abtastung der Messteilung (20, 30) in einem Pulsbetrieb,
wobei eine Taktüberwachungseinheit (410) vorhanden ist, der das Messtaktsignal (M_CLK) und/oder ein aus dem Messtaktsignal (M_CLK) resultierendes Taktsignal (V_CLK) zur Überwachung zugeführt wird und die einen zweiten Taktgenerator (420) zur Erzeugung eines Testtaktsignals (T_CLK), eine erste Vergleichereinheit (430), der das Testtaktsignal (T_CLK) und eines der zu überwachenden Taktsignale (M_CLK, V_CLK) zugeführt wird und in der ein Vergleich der zugeführten Taktsignale (T_CLK, M_CLK, V_CLK) durchgeführt wird und einen Fehlerspeicher (440), in dem ein Ergebnis des Vergleichs als Statusinformation (STAT) gespeichert wird, umfasst.

9. Verfahren nach Anspruch 8, wobei die Taktüberwachungseinheit (410) weiter eine zweite Vergleichereinheit (450) umfasst, der das Testtaktsignal (T_CLK) und ein weiteres der zu überwachenden Taktsignale (T_CLK, M_CLK, V_CLK) zugeführt werden und in der ein Vergleich der zugeführten Taktsignale (T_CLK, M_CLK, V_CLK) durchgeführt wird und ein Ergebnis des Vergleichs ebenfalls als Statusinformation (STAT) im Fehlerspeicher (440) gespeichert wird.

10. Verfahren nach einem Ansprüche 8 oder 9, wobei in den Vergleichereinheiten (430, 450) der Vergleich durch Feststellung einer Anzahl von Zustandswechseln eines ersten der zu vergleichenden Taktsignale (T_CLK, M_CLK, V_CLK) innerhalb eines Zeitintervalls, das von einem zweiten der zu vergleichenden Taktsignale (T_CLK, M_CLK, V_CLK) bestimmt wird, durchgeführt wird.

11. Verfahren nach Anspruch 10, wobei das Zeitintervall durch die Periodendauer des zweiten zu vergleichenden Taktsignals (T_CLK, M_CLK, V_CLK) bestimmt wird.

12. Verfahren nach einem der Ansprüche 9 oder 10, wobei zur Feststellung der Anzahl von Zustandswechseln steigende oder/und fallende Signalflanken des ersten der zu vergleichenden Taktsignale (T_CLK, M_CLK, V_CLK) innerhalb des Zeitintervalls gezählt werden.

13. Verfahren nach einem der Ansprüche 8 bis 12, wobei der Taktüberwachungseinheit (410) ein Testsignal (TEST) zuführbar ist, das eine Änderung der Periodendauer des Testtaktsignals (T_CLK) bewirkt, so dass ein Fehler beim Vergleich der Taktsignale (T_CLK, M_CLK, V_CLK) erzwungen wird.

14. Verfahren nach einem der Ansprüche 8 bis 13, wobei im Pulsbetrieb nur Komponenten von einer Batterie (320) mit Strom versorgt werden, die sich in einem batteriegestützten Bereich (330) befinden und die Schnittstelleneinheit (250) außerhalb des batteriebetriebenen Bereichs (330) angeordnet ist.

15. Verfahren nach einem der Ansprüche 13 oder 14, wobei der Taktüberwachungseinheit (410) das Testsignal (TEST) nach einem Übergang vom Pulsbetrieb in einen Normalbetrieb, in dem auch die Schnittstelleneinheit (250) mit Strom versorgt wird, von der Folgeelektronik (280) zugeführt wird.

## Claims

1. Multiturn rotary encoder having
- a graduation carrier (10) with a measurement graduation (20, 30),
- a scanning device (40, 140) which can be used to scan the measurement graduation (20, 30) in order to generate position signals (PS, PS1, PS2),
- a processing unit (100) which can be used to process the position signals (PS, PS1, PS2) to form position values (POS, POS1, POS2),
- an interface unit (250) for communicating with downstream electronics (280) via a data transmission channel (260), and
- a first clock generator (400) for generating a measurement clock signal (M_CLK) for controlling the scanning of the measurement graduation (20, 30) in pulsed operation,
wherein a clock monitoring unit (410) is present, to which the measurement clock signal (M_CLK) and/or a clock signal (V_CLK) resulting from the measurement clock signal (M_CLK) is/are supplied for monitoring and which comprises a second clock generator (420) for generating a test clock signal (T_CLK), a first comparator unit (430), to which the test clock signal (T_CLK) and one of the clock signals (M_CLK, V_CLK) to be monitored are supplied and in which the supplied clock signals (T_CLK, M_CLK, V_CLK) can be compared, and an error memory (440) in which a result of the comparison can be stored as status information (STAT).

2. Multiturn rotary encoder according to Claim 1, wherein the clock monitoring unit (410) also comprises a second comparator unit (450), to which the test clock signal (T_CLK) and a further one of the clock signals (M_CLK, V_CLK) to be monitored are supplied and in which the supplied clock signals (T_CLK, M_CLK, V_CLK) can be compared, and a result of the comparison can likewise be stored as status information (STAT) in the error memory (440).

3. Multiturn rotary encoder according to one of the preceding claims, wherein the comparison is carried out in the comparator units (430, 450) by determining a number of state changes of a first one of the clock signals (T_CLK, M_CLK, V_CLK) to be compared within an interval of time which is determined by a second one of the clock signals (T_CLK, M_CLK, V_CLK) to be compared.

4. Multiturn rotary encoder according to Claim 3, wherein the interval of time is determined by the period duration of the second clock signal (T_CLK, M_CLK, V_CLK) to be compared.

5. Multiturn rotary encoder according to either of Claims 3 and 4, wherein the number of state changes is determined by counting rising or/and falling signal edges of the first one of the clock signals (T_CLK, M_CLK, V_CLK) to be compared within the interval of time.

6. Multiturn rotary encoder according to one of the preceding claims, wherein a test signal (TEST) which changes the period duration of the test clock signal (T_CLK) can be supplied to the clock monitoring unit (410), thus forcing an error when comparing the clock signals (T_CLK, M_CLK, V_CLK).

7. Multiturn rotary encoder according to one of the preceding claims, wherein, during pulsed operation, only components which are in a battery-supported area (330) are supplied with power by a battery (320), and the interface unit (250) is arranged outside the battery-operated area (330).

8. Method for operating a multiturn rotary encoder having
- a graduation carrier (10) with a measurement graduation (20, 30),
- a scanning device (40, 140) which is used to scan the measurement graduation (20, 30) in order to generate position signals (PS, PS1, PS2),
- a processing unit (100) which is used to process the position signals (PS, PS1, PS2) to form position values (POS, POS1, POS2),
- an interface unit (250) for communicating with downstream electronics (280) via a data transmission channel (260), and
- a first clock generator (400) for generating a measurement clock signal (M_CLK) for controlling the scanning of the measurement graduation (20, 30) in pulsed operation,
wherein a clock monitoring unit (410) is present, to which the measurement clock signal (M_CLK) and/or a clock signal (V_CLK) resulting from the measurement clock signal (M_CLK) is/are supplied for monitoring and which comprises a second clock generator (420) for generating a test clock signal (T_CLK), a first comparator unit (430), to which the test clock signal (T_CLK) and one of the clock signals (M_CLK, V_CLK) to be monitored are supplied and in which the supplied clock signals (T_CLK, M_CLK, V_CLK) are compared, and an error memory (440) in which a result of the comparison is stored as status information (STAT).

9. Method according to Claim 8, wherein the clock monitoring unit (410) also comprises a second comparator unit (450), to which the test clock signal (T_CLK) and a further one of the clock signals (T_CLK, M_CLK, V_CLK) to be monitored are supplied and in which the supplied clock signals (T_CLK, M_CLK, V CLK) are compared, and a result of the comparison is likewise stored as status information (STAT) in the error memory (440).

10. Method according to either of Claims 8 and 9, wherein the comparison is carried out in the comparator units (430, 450) by determining a number of state changes of a first one of the clock signals (T_CLK, M_CLK, V_CLK) to be compared within an interval of time which is determined by a second one of the clock signals (T_CLK, M_CLK, V_CLK) to be compared.

11. Method according to Claim 10, wherein the interval of time is determined by the period duration of the second clock signal (T_CLK, M_CLK, V_CLK) to be compared.

12. Method according to either of Claims 9 and 10, wherein, in order to determine the number of state changes, rising or/and falling signal edges of the first one of the clock signals (T_CLK, M_CLK, V_CLK) to be compared are counted within the interval of time.

13. Method according to one of Claims 8 to 12, wherein a test signal (TEST) which changes the period duration of the test clock signal (T_CLK) can be supplied to the clock monitoring unit (410), thus forcing an error when comparing the clock signals (T CLK, M_CLK, V_CLK).

14. Method according to one of Claims 8 to 13, wherein, during pulsed operation, only components which are in a battery-supported area (330) are supplied with power by a battery (320), and the interface unit (250) is arranged outside the battery-operated area (330).

15. Method according to either of Claims 13 and 14, wherein the test signal (TEST) is supplied to the clock monitoring unit (410) by the downstream electronics (280) after a transition from pulsed operation to normal operation in which the interface unit (250) is also supplied with power.

## Revendications

1. Codeur multi-tours comprenant
- un support gradué (10) pourvu d'une graduation de mesure (20, 30),
- un dispositif de balayage (40, 140) permettant de balayer la graduation de mesure (20, 30) afin de générer des signaux de position (PS, PS1, PS2),
- une unité de traitement (100) permettant de traiter les signaux de position (PS, PS1, PS2) pour obtenir des valeurs de position (POS, POS1, POS2),
- une unité d'interface (250) destinée à la communication avec l'électronique ultérieure (280) par le biais d'un canal de transmission de données (260) et
- un premier générateur d'horloge (400) destiné à générer un signal d'horloge de mesure (M_CLK) pour commander le balayage de la graduation de mesure (20, 30) en mode impulsionnel,
une unité de surveillance d'horloge (410) étant prévue à laquelle sont amenés le signal d'horloge de mesure (M_CLK) et/ou un signal d'horloge (V_CLK) à surveiller résultant du signal d'horloge de mesure (M_CLK) et qui comprend un deuxième générateur d'horloge (420) destiné à générer un signal d'horloge de test (T_CLK), une première unité de comparaison (430) à laquelle sont amenés le signal d'horloge de test (T_CLK) et l'un des signaux d'horloge (M_CLK, V_CLK) à surveiller et dans laquelle une comparaison des signaux d'horloge (T_CLK, M_CLK, V_CLK) amenés peut être effectuée et une mémoire d'erreur (440) dans laquelle un résultat de la comparaison peut être stocké sous forme d'information d'état (STAT).

2. Codeur multi-tour selon la revendication 1, l'unité de surveillance d'horloge (410) comprenant en outre une deuxième unité de comparaison (450) à laquelle sont amenés le signal d'horloge de test (T_CLK) et un autre des signaux d'horloge (M_CLK, V_CLK) à surveiller et dans laquelle une comparaison des signaux d'horloge (T_CLK, M_CLK, V_CLK) amenés peut être effectuée et un résultat de la comparaison peut être stocké dans la mémoire d'erreur (440) également sous forme d'information d'état (STAT).

3. Codeur multi-tours selon l'une des revendications précédentes, la comparaison étant effectuée dans les unités de comparaison (430, 450) par détermination d'un certain nombre de changements d'état d'un premier des signaux d'horloge (T_CLK, M_CLK, V_CLK) à comparer dans un intervalle de temps qui est déterminé par un deuxième des signaux d'horloge (T_CLK, M_CLK, V_CLK) à comparer.

4. Codeur multi-tours selon la revendication 3, l'intervalle de temps étant déterminé par la durée de période du deuxième signal d'horloge (T_CLK, M_CLK, V_CLK) à comparer.

5. Codeur multi-tours selon l'une des revendications 3 ou 4, la détermination du nombre de changements d'état étant effectuée par comptage des fronts de signal montants et/ou descendants du premier des signaux d'horloge (T_CLK, M_CLK, V_CLK) à comparer dans l'intervalle de temps.

6. Codeur multi-tours selon l'une des revendications précédentes, un signal de test (TEST) pouvant être amené à l'unité de surveillance d'horloge (410) et provoquant une modification de la durée de période du signal d'horloge de test (T_CLK) de façon à forcer une erreur lors de la comparaison des signaux d'horloge (T_CLK, M_CLK, V_CLK).

7. Codeur multi-tours selon l'une des revendications précédentes, seuls les composants d'une batterie (320) sont alimentés en courant en mode impulsionnel, lesquels composants sont situés dans une zone (330) alimentée par la batterie et l'unité d'interface (250) étant disposée à l'extérieur de la zone (330) alimentée par la batterie.

8. Procédé de fonctionnement d'un codeur multi-tours comprenant
- un support gradué (10) pourvu d'une graduation de mesure (20, 30),
- un dispositif de balayage (40, 140) permettant de balayer la graduation de mesure (20, 30) afin de générer des signaux de position (PS, PS1, PS2),
- une unité de traitement (100) permettant de traiter les signaux de position (PS, PS1, PS2) pour obtenir des valeurs de position (POS, POS1, POS2),
- une unité d'interface (250) destinée à la communication avec l'électronique ultérieure (280) par le biais d'un canal de transmission de données (260) et
- un premier générateur d'horloge (400) destiné à générer un signal d'horloge de mesure (M_CLK) pour commander le balayage de la graduation de mesure (20, 30) en mode impulsionnel,
une unité de surveillance d'horloge (410) étant prévue à laquelle sont amenés le signal d'horloge de mesure (M_CLK) et/ou un signal d'horloge (V_CLK) à surveiller résultant du signal d'horloge de mesure (M_CLK) et qui comprend un deuxième générateur d'horloge (420) destiné à générer un signal d'horloge de test (T_CLK), une première unité de comparaison (430) à laquelle sont amenés le signal d'horloge de test (T_CLK) et l'un des signaux d'horloge (M_CLK, V_CLK) à surveiller et dans laquelle une comparaison des signaux d'horloge (T_CLK, M_CLK, V_CLK) amenés peut être effectuée et une mémoire d'erreur (440) dans laquelle un résultat de la comparaison peut être stocké sous forme d'information d'état (STAT).

9. Procédé selon la revendication 8, l'unité de surveillance d'horloge (410) comprenant en outre une deuxième unité de comparaison (450) à laquelle sont amenés le signal d'horloge de test (T_CLK) et un autre des signaux d'horloge (T_CLK, M_CLK, V_CLK) à surveiller et dans laquelle une comparaison des signaux d'horloge (T_CLK, M_CLK, V_CLK) amenés peut être effectuée et un résultat de la comparaison peut être stocké dans la mémoire d'erreur (440) également sous forme d'information d'état (STAT).

10. Procédé selon la revendication 8 ou 9, la comparaison étant effectuée dans les unités de comparaison (430, 450) par détermination d'un certain nombre de changements d'état d'un premier des signaux d'horloge (T_CLK, M_CLK, V_CLK) à comparer dans un intervalle de temps qui est déterminé par un deuxième des signaux d'horloge (T_CLK, M_CLK, V_CLK) à comparer.

11. Procédé selon la revendication 10, l'intervalle de temps étant déterminé par la durée de période du deuxième signal d'horloge (T_CLK, M_CLK, V_CLK) à comparer.

12. Procédé selon l'une des revendications 9 ou 10, des fronts de signal montants et/ou descendants du premier des signaux d'horloge (T_CLK, M_CLK, V_CLK) à comparer étant comptés dans l'intervalle de temps pour déterminer le nombre de changements d'état.

13. Procédé selon l'une des revendications 8 à 12, un signal de test (TEST) pouvant être amené à l'unité de surveillance d'horloge (410) et provoquant une modification de la durée de période du signal d'horloge de test (T_CLK) de façon à forcer une erreur lors de la comparaison des signaux d'horloge (T_CLK, M_CLK, V_CLK).

14. Procédé selon l'une des revendications 8 à 13, seuls les composants d'une batterie (320) sont alimentés en courant en mode impulsionnel, lesquels composants sont situés dans une zone (330) alimentée par la batterie et l'unité d'interface (250) étant disposée à l'extérieur de la zone (330) alimentée par la batterie.

15. Procédé selon l'une des revendications 13 ou 14, le signal de test (TEST) étant amené de l'électronique ultérieure (280) à l'unité de surveillance d'horloge (410) après une transition du mode impulsionnel au mode normal dans lequel l'unité d'interface (250) est également alimentée en courant.
